# EUROPEAN PATENT APPLICATION

(11) **EP 2 091 155 A1**
(43) Date of publication of application: **19.08.2009**
(21) Application number: 09152581.6
(22) Date of filing: 11.02.2009
(51) Int. Cl.: H03L 7/16, G01R 23/14

(54) **Phase-locked loop system and method**

(30) Priority: 15.02.2008 US 32570
(71) Applicant: TEKTRONIX, INC., Beaverton, OR 97077 (US)
(72) Inventor: Li, Litong, Portland, OR 97229 (US)
(74) Representative: Schurack, Eduard F.

(57) **Abstract**

A phase-locked loop including a phase detector (34) configured to receive inputs from a reference signal path and a feedback signal path and generate a phase detector output based upon such inputs. The phase-locked loop also includes an oscillator (36) operatively coupled with the phase detector and configured to produce an oscillatory output in response to and based upon the phase detector output, and where the oscillatory output is applied to the feedback signal path. The reference signal path includes a mixer (74) configured to mix a reference signal with output from a direct digital synthesizer (72); and a switching mechanism (86,88) configured to selectively place one of a plurality of different filters (82,84) in series between the mixer and the phase detector. The phase locked loop may be used in a low phase noise and wide tuned PLL handheld electronic test and measurement device.

## Description

### BACKGROUND

A wide variety of devices exist for testing, measuring and analyzing digital and analog signals. Phase-locked loops (PLLs) are often employed in these devices to perform various functions. Performance requirements for the PLL will often depend on the particular setting, though a wide variety of applications benefit from the PLL having low phase noise and high tuning resolution over a wide frequency range. Design challenges commonly arise from the fact that improving one performance parameter can cause degradation of another. For example, certain solutions that optimize phase noise can introduce spurious power in the output signal.

In addition, performance requirements normally need to be balanced with considerations of cost, size, packaging and power consumption. A particular design might provide an optimal blend of performance, for example, but consume too much power to be implemented within a battery-powered portable device.

### BRIEF DESCRIPTION OF THE DRAWINGS

Fig. 1 schematically depicts an electronic device for testing, measuring and/or analyzing an electrical signal, including a phase-locked loop subsystem disposed within the device.
Figs. 2 - 4 schematically depict further examples of phase-locked loop subsystems that may be employed in the device of Fig. 1.
Fig. 5 illustrates an exemplary data plot that may be used to assess control strategies to be applied in a reference signal path of the phase-locked loop subsystem example shown in Fig. 4.
Fig. 6 depicts an exemplary phase-locked loop method.

### DETAILED DESCRIPTION

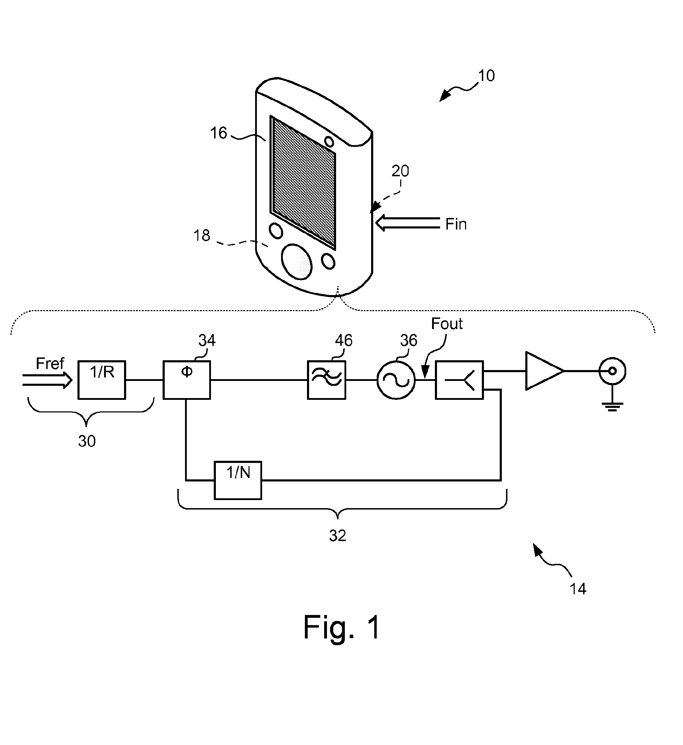

Fig. 1 depicts an electronic device 10 which may be used to test, measure and/or analyze an electrical signal Fin. The depicted example device is portable (e.g., handheld), and includes a PLL subsystem 14 disposed within a housing 16 and powered by battery 18. As described herein, PLL subsystem 14 may be optimized for advantageous use in a portable device, as shown in the example, though it will be appreciated that the described PLL subsystem may be used in other devices.

Device 10 includes an input 20 for receiving the signal Fin. The signal may be received wired or wirelessly. A PLL reference signal Fref may be derived from the input electrical signal and applied to PLL subsystem 14 via a reference signal path 30 of the PLL subsystem. In some embodiments, the PLL reference signal Fref can be generated from an oscillator within device 10. In this manner, the reference clock can be used to provide low phase noise performance on the PLL output. For example, a system reference clock may be a clear enough signal to not impact system phase noise performance at a specific frequency offset.

PLL subsystem 14 also includes a feedback signal path 32. The reference signal path and feedback signal path are coupled with a phase detector 34, which is responsive to phase differences between signals received at its inputs. An oscillator 36 is operatively controlled by the phase detector through loop filter 46 and is driven to produce an oscillatory output Fout in response to the phase detector's output. The previously-mentioned feedback signal path occurs between the output of oscillator 36 and the phase detector input. The depicted scheme provides negative feedback which causes the oscillator output Fout to tend toward and preferably lock into characteristics (e.g., an output frequency and phase offset) determined by the PLL reference signal Fref. The reference signal path and/or feedback signal path may include dividers to achieve a desired output-input frequency ratio, filters to appropriately condition the signal path, and other components as desired.

In many settings it will be desirable that oscillator 36 be implemented with a wide-tuning voltage-controlled oscillator (VCO), and that the PLL have low phase noise. To reduce sideband phase noise, components may be selected to widen the loop bandwidth. Furthermore, a commercial synthesizer may be employed in many settings to achieve low power consumption, as may be desirable in a handheld or other portable device operating on batteries. Such a combination may, however, result in the synthesizer producing undesirably high phase noise.

Accordingly, reduction in the synthesizer noise contribution may be reduced by increasing the comparing frequency presented to phase detector 34. In an integral dividing ratio PLL, the comparing frequency can be increased by increasing the tuning step of the PLL. This decrease in resolution will be unacceptable in many applications, and it may therefore be desirable to employ direct digital synthesis (DDS) in the reference signal path. DDS can provide very fine resolution frequency tuning with very low phase noise.

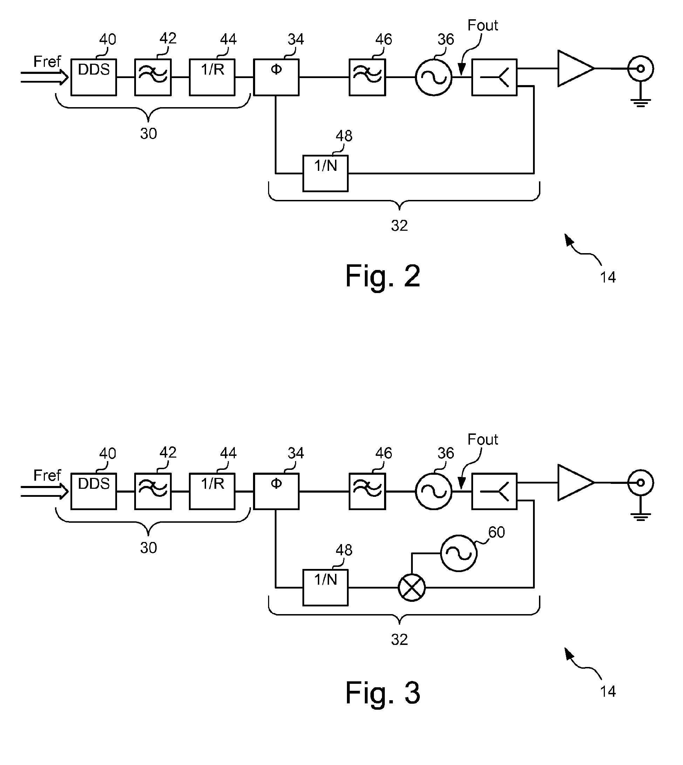

Fig. 2 provides a further example embodiment of PLL subsystem 14, in which DDS is employed in reference signal path 30. Specifically, the depicted example reference signal path 30 includes a DDS block 40, low-pass filter 42, and divider 44 feeding into phase detector 34. The phase detector output drives oscillator 36 (e.g., a VCO) via loop filter 46 to produce oscillatory output Fout. The feedback signal path 32 may also include a divider 48, which may be selected in combination with divider 44 to provide desired frequency multiplication and/or tune other aspects of PLL performance.

Fig. 3 provides another DDS-enabled example, similar to the example of Fig. 2, but with a comb generator 60 mixed into the feedback signal path 32 to provide synchronization and output stability.

The examples of Figs. 2 and 3 thus provide a wide tuning range and high resolution, while reducing phase noise. These configurations may, however, be more prone than other configurations to producing undesirable frequency spurs in the PLL output spectrum. In particular, the depicted use of DDS in Figs 2 and 3 can produce the n*Fref+/-m*Fdds spur. The higher the DDS output frequency relative to the reference frequency of Fref, the higher the spur level is.

In order to use a lower DDS output frequency and keep the comparing frequency of a phase detector high, an embodiment may up-convert a DDS output frequency with a DDS input frequency, however, in some embodiments a different signal source may be used. For example, in one approach a fractional synthesizer or a more complex system may be replace the DDS, however, to achieve a similar low spurious level, up-converting may still be needed.

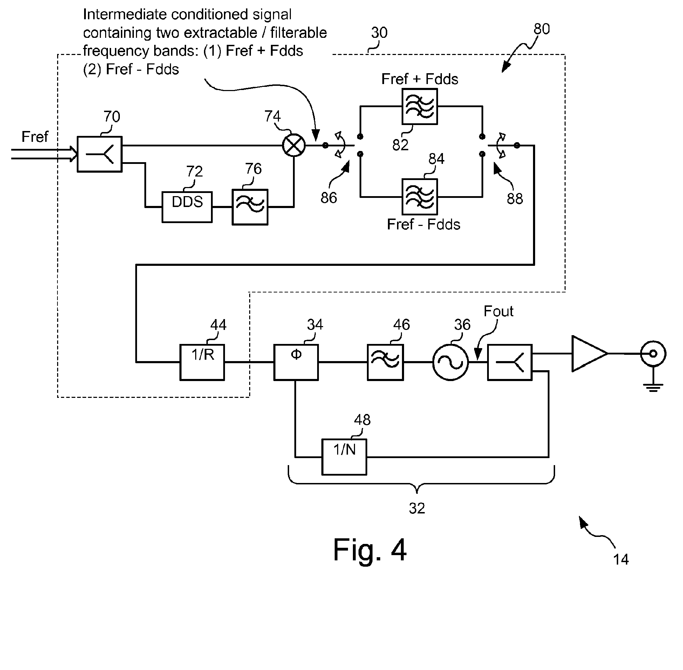

Fig. 4 depicts a further example embodiment of PLL subsystem 14. As will be explained, the example of this figure may achieve many or all of the advantages of the other examples, while further eliminating or reducing undesirable spurs in the output spectrum. In particular, the example of Fig. 4 contemplates processing and/or signal conditioning in reference signal path 30 to achieve a plurality of extractable (e.g., selectable through filtering) components. Depending on operating conditions, the spurious noise and/or other performance conditions in one of the components will be relatively more or less desirable than that experienced with the other components. The preferred component may then be selected (e.g., filtered) for pass through to phase detector 34.

Specifically, as shown in Fig. 4, PLL reference signal Fref may be split at 70 in reference signal path 30 so that Fref drives DDS block 72 and mixer 74. Subsequent to low-pass filter 76, the DDS output is mixed with Fref at mixer 74. Disposed between mixer 74 and phase detector 34 is switching mechanism 80, which is configured to selectively place a desired filter in series between the mixer output and the reference input of phase detector 34.

In various other respects, the depicted example may be similar to that described with reference to Figs. 2 and 3. In addition to phase detector 34, the main loop of the depicted embodiment may also include a loop filter 46 and VCO 36, the output of which (Fout) is fed back to the phase detector. Also, as in the previous examples, dividers 44 and 48 may be provided in the signal paths to the phase detector to provide frequency multiplication and otherwise tune performance as appropriate.

One approach to reduce spur levels in the depicted example involves setting the output frequency of the DDS block 72 relative to the frequency of Fref. In particular, it was determined that setting the output frequency of the DDS block to a range up to 1/8 of the frequency of Fref may effectively reduce spur levels, but other embodiments are not so limited. Mixer 74 is then used to increase the comparing frequency at 34. In the present example, by setting the output frequency of the DDS block to around 1/8 of the Fref frequency, will keep the minimum order of mixing of the DDS and the Fref below the 8^{th} order, while also providing a wide tuning range. As the result of the mixing at 74, two frequency bands are obtained in the intermediate conditioned signal: (1) Fref+Fdds and (2) Fref-Fdds. In the depicted example, only one of the bands is used as a clock to phase detector 34, and switching mechanism 80 is used to select the appropriate band.

Numerous possibilities exist for selecting the appropriate band. In the present examples, filters 82 and 84 are employed. In some embodiments, filters 82 and 84 may be various be any of various band-pass filters. In one particular embodiment, filters 82 and 84 may be surface acoustic wave (SAW) filters.Other embodiments are not so limited and may use other suitable filters. One or the other of the filters 82 and 84 is activated through operation of switches 86 and 88, so as to place the selected filter in series between the mixer and the phase detector. In some embodiments using a commercial integral synthesizer, the highest power detector frequency may be limited. To illustrate, If a prescaler ratio is P, a divide ratio on the feedback signal path is N=B*P+A, B>A. In this way, the Fref + Fdds path and Fref - Fdds path, as explained herein, can be used to optimize the PLL for best phase noise.

In particular, by using the two tuning bands, the depicted topology leverages the full DDS tuning to provide optimized phase noise and spurious performance. This configuration simplifies the high frequency section and allows filtering to happen at relatively low frequencies. Furthermore, the example embodiment may be implemented without using high-power consumption components such as YIG VCOs, and GaAs frequency dividers and phase detectors. Indeed, the inventors have designed entire PLL systems as described herein with power consumption of less then 1.5W. This ability to implement the design with low power components makes it suitable for use in portable high performance products.

Control conditions for switches 86 and 88 may be determined in a variety of ways. According to one approach, reference signals spanning the operational frequency range may be applied successively to PLL subsystem 14 to empirically observe spur response, phase noise and other aspects of PLL performance. A first sweep across the frequency range might be performed using only filter 82. Then a second sweep would be performed for the other filter 84. The obtained data would then be compared to make point-by-point or regional comparisons to determine the appropriate filter for use under different conditions.

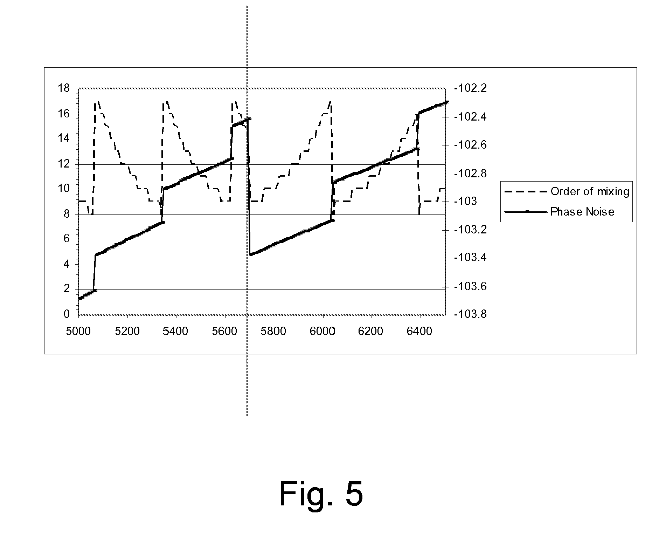

Fig. 5, for example, shows an exemplary performance comparison of the PLL subsystem of Fig. 4 when using filters 82 and 84. The right vertical axis represents the lowest order of mixing between the Fref and the Fdds, and the left vertical axis represents phase noise. In general, as the mixing order decreases, spur performance increases. As phase noise increases, an embodiment can switch to the other band and keep phase noise relatively low while maintaining a mixing order higher than 8. In the illustrated example in Fig. 5, the bands are switched from filter 82 to filter 84 near the horizontal dashed line near 5700 on the X-axis.

Other aspects of PLL performance may be similarly assessed to determine appropriate control of switches 86 and 88. Phase noise performance may be plotted, for example, as a function of frequency or another parameter for each of filters 82 and 84. Spur levels and phase noise are but two examples, many other aspects of PLL performance may be accounted for in the control of switches 86 and 88.

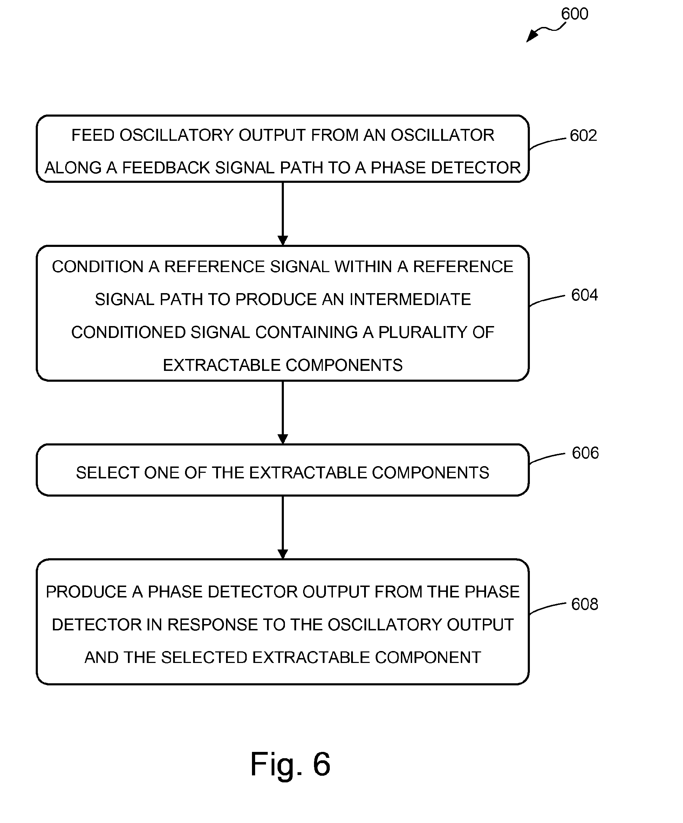

From the above, it will be appreciated that in addition to the described structures, the present description encompasses methods of configuring and/or operating a phase-locked loop. Fig. 6 depicts an exemplary method 600 for operating a phase-locked loop. At 602, the method includes feeding oscillatory output from an oscillator along a feedback signal path to a phase detector. At 604, the method includes conditioning a reference signal within a reference signal path to produce an intermediate conditioned signal containing a plurality of extractable components. One of the extractable components is selected at step 606. At 608, the method includes producing a phase detector output from the phase detector in response to the oscillatory output and the selected extractable component.

From the above, it should be appreciated that the conditioning referenced at 604 may be performed by mixing the PLL reference signal with the output of a DDS block in order to generate multiple frequency band components in the signal. In such a case, the selection at 606 may be performed by selectively controlling activation of different filters to act upon the mixer output.

It will further be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated may be performed in the sequence illustrated, in other sequences, in parallel, or in some cases omitted. Likewise, the order of any of the above-described processes is not necessarily required to achieve the features and/or results of the embodiments described herein, but is provided for ease of illustration and description. The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A low phase noise and wide tuned PLL handheld electronic test and measurement device, comprising
a housing;
a battery connector disposed within the housing and configured to receive a battery;
an input configured to receive a signal of interest;
a phase-locked loop (PLL) subsystem disposed within the housing and configured to be powered by the battery, the PLL subsystem including a reference signal path operatively coupled with the input and configured to receive a reference signal derived from the signal of interest, where the PLL subsystem further includes:
a phase detector operatively coupled with the reference signal path and a feedback signal path and configured to generate a phase detector output based upon signals applied to the phase detector from the reference signal path and the feedback signal path; and
an oscillator operatively coupled with the phase detector and configured to produce an oscillatory output in response to and based upon the phase detector output, and where the oscillatory output is applied to the feedback signal path,
where the reference signal path includes:
a mixer configured to mix the reference signal with output from a direct digital synthesizer; and
a switching mechanism configured to selectively place one of a plurality of different filters in series between the mixer and the phase detector.

2. The device of claim 1, where the direct digital synthesizer is configured so that its output has a frequency no greater than approximately 1/8 of a frequency of the reference signal.

3. The device of claim 2, where one of the plurality of different filters is configured as a band pass filter centered at a frequency equal to the frequency of the reference signal plus the frequency of the output of the direct digital synthesizer, and
where another of the plurality of different filters is configured as a band pass filter centered at a frequency equal to the frequency of the reference signal minus the frequency of the output of the direct digital synthesizer.

4. The device of claim 2, where the switching mechanism is configured to selectively place either a first filter or a second filter in series between the mixer and the phase detector, and where the first filter and the second filter are band pass filters having different center frequencies.

5. The device of claim 4, where the first filter and the second filter are surface acoustic wave (SAW) filters.

6. The device of claim 4, where the switching mechanism is configured to selectively place either the first filter or the second filter in series between the mixer and the phase detector dependent upon an operating parameter of the PLL subsystem.

7. The device of claim 6, where the operating parameter is a frequency of the reference signal.

8. The device of claim 7, where the switching mechanism is configured so that the first filter is placed in series between the mixer and the phase detector when the frequency of the reference signal is in an lower range and when the frequency of the reference signal is in a upper range, and so that the second filter is placed in series between the mixer and the phase detector when the frequency of the reference signal is in an intermediate range between the lower range and the upper range.

9. A phase-locked loop, comprising:
a phase detector configured to receive inputs from a reference signal path and a feedback signal path and generate a phase detector output based upon such inputs; and
an oscillator operatively coupled with the phase detector and configured to produce an oscillatory output in response to and based upon the phase detector output, and where the oscillatory output is applied to the feedback signal path,
where the reference signal path includes:
a mixer configured to mix a reference signal with output from a direct digital synthesizer; and
a switching mechanism configured to selectively place one of a plurality of different filters in series between the mixer and the phase detector.

10. The phase-locked loop of claim 9, where the direct digital synthesizer is configured so that its output has a frequency no greater than approximately 1/8 of a frequency of the reference signal.

11. The phase-locked loop of claim 10, where one of the plurality of different filters is configured as a band pass filter centered at a frequency equal to the frequency of the reference signal plus the frequency of the output of the direct digital synthesizer, and
where another of the plurality of different filters is configured as a band pass filter centered at a frequency equal to the frequency of the reference signal minus the frequency of the output of the direct digital synthesizer.

12. The phase-locked loop of claim 9, where the switching mechanism is configured to selectively place either a first filter or a second filter in series between the mixer and the phase detector, and where the first filter and the second filter are band pass filters having different center frequencies.

13. The phase-locked loop of claim 12, where the first filter and the second filter are surface acoustic wave (SAW) filters.

14. The phase-locked loop of claim 12, where the switching mechanism is configured to selectively place either the first filter or the second filter in series between the mixer and the phase detector dependent upon an operating parameter of the phase-locked loop.

15. The phase-locked loop of claim 14, where the operating parameter is a frequency of the reference signal.

16. The phase-locked loop of claim 15, where the switching mechanism is configured so that the first filter is placed in series between the mixer and the phase detector when the frequency of the reference signal is in an lower range and when the frequency of the reference signal is in a upper range, and so that the second filter is placed in series between the mixer and the phase detector when the frequency of the reference signal is in an intermediate range between the lower range and the upper range.

17. A phase-locked loop method, comprising:
feeding oscillatory output from an oscillator along a feedback signal path to a phase detector;
within a reference signal path, conditioning a reference signal to produce an intermediate conditioned signal containing a plurality of extractable components;
selecting one of the extractable components; and
producing a phase detector output from the phase detector in response to the oscillatory output and the one of the extractable components.

18. The method of claim 17, where conditioning the reference signal to produce an intermediate conditioned signal includes mixing the reference signal with output from a direct digital synthesizer.

19. The method of claim 18, where selecting one of the extractable components includes band-pass filtering output from the mixing of the reference signal with the output of the direct digital synthesizer.

20. The method of claim 18, where selecting one of the extractable components includes switching output from the mixing of the reference signal with the output of the direct digital synthesizer to either a first filter or a second filter.
